(19) Europäisches Patentamt
European Patent Office
Office européen des brevets

(11) **EP 4 425 726 A1**

(12) **EUROPEAN PATENT APPLICATION**

(43) Date of publication:
**04.09.2024 Bulletin 2024/36**

(21) Application number: **23159062.1**

(22) Date of filing: **28.02.2023**

(51) International Patent Classification (IPC):
**H01S 5/065** (2006.01)    **H01S 5/00** (2006.01)
**H01S 5/062** (2006.01)    **G01S 7/481** (2006.01)
**H01S 5/06** (2006.01)     **H01S 5/0687** (2006.01)

(52) Cooperative Patent Classification (CPC):
**H01S 5/0622; H01S 5/0085; H01S 5/0656;**
G01S 7/4911; H01S 5/02325; H01S 5/0617;
H01S 5/0654; H01S 5/0687

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicants:
• **Imec VZW**
  **3001 Leuven (BE)**

• **Universiteit Gent**
  **9000 Gent (BE)**

(72) Inventor: **MORTHIER, Geert**
  **9031 Drongen (BE)**

(74) Representative: **AWA Sweden AB**
  **Box 5117**
  **200 71 Malmö (SE)**

(54) **LASER APPARATUS AND METHOD FOR CONTROLLING THE LINEWIDTH OF THE EMITTED LASER BEAM**

(57)    There is provided a laser apparatus comprising:
a laser diode for emitting a laser beam, configured for frequency modulation of the laser beam;
a sensor unit configured to receive a first portion of the laser beam, and for measuring variations of the frequency of the first portion;
a phase shifter arranged in a path of a second portion of the laser beam, and configured to phase shift the second portion propagating through the phase shifter.

The laser apparatus is configured to output the sec-

ond portion having propagated through the phase shifter, and to acquire a plurality of measurements of variations of the frequency during frequency modulation at different phase shifts, and to control the phase shifter based on the plurality of measurements to control the variations of the frequency, whereby the laser apparatus may control a linewidth of the laser beam in dependence of an external reflection of the output laser beam, received by the laser apparatus.

Fig. 1

**Description**

Technical field

The present description relates to the field of laser diodes, and more specifically to a laser apparatus and a method for controlling the linewidth of a laser beam emitted by the laser apparatus.

Background

Since the creation of the first laser, the number of fields in which lasers are applied has continued to grow. Today laser diodes are used in a vast variety of applications ranging from advanced research equipment, medical applications, and 3D sensing to data and telecommunication, and home electronics.

A challenge with laser diodes is that they are very sensitive to external reflections of the emitted laser light. External reflections may enter into the laser diode and this will affect the performance of the laser diode. For example, external reflections received in the laser diode can affect the linewidth of the emitted laser light, and in case of the external reflections being very strong the reflections may also result in coherence collapse.

However, a narrow laser linewidth is important in several laser based application such as optical communications, optical sensing, laser-induced fluorescence (LIF), and light detection and ranging (LIDAR). Thus, linewidth broadening as a result of external reflections entering the laser diode may significantly reduce the performance of the laser in the intended application. Linewidth broadening is therefore undesired.

A frequently used alternative to tackle the negative effects on laser performance caused by parasitic external reflections is to arrange an optical isolator in front of the laser diode. The purpose of the optical isolator is to shield any external reflections from entering into the laser diode. However, an optical isolator comprises magneto-optic materials and therefore suffers from the disadvantage that it can not be integrated on the same substrate as the laser diode. Solutions using optical isolator are therefore relatively bulky, and thus not suitable where compact laser solutions are required.

Hence, there is a need in the art for further improvements related to laser diodes.

Summary

An objective of the present description is to mitigate, alleviate or eliminate one or more of the above-identified deficiencies in the art and disadvantages singly or in any combination. These and other objectives are at least partly met by the invention as defined in the independent claims. Preferred embodiments are set out in the dependent claims.

According to a first aspect there is provided a laser apparatus comprising:

a laser diode configured to emit a laser beam, wherein the laser diode is further configured for frequency modulation of the laser beam;
a sensor unit configured to receive a first portion of the laser beam, wherein the sensor unit is further configured for measuring variations of the frequency of the first portion of the laser beam;
a phase shifter arranged in a path of a second portion of the laser beam, and configured to generate a phase shift of the second portion of the laser beam propagating through the phase shifter;
wherein the laser apparatus is configured to output the second portion of the laser beam having propagated through the phase shifter; and
wherein the laser apparatus is configured to acquire, by the sensor unit, a plurality of measurements of the variations of the frequency during frequency modulation at a plurality of different phase shifts generated by the phase shifter, and to control the phase shifter based on the plurality of measurements so as to control the variations of the frequency, whereby the laser apparatus is configured to control a linewidth of the laser beam in dependence of an external reflection of the second portion of the laser beam being output, received by the laser apparatus.

By the term "laser diode" is here meant any diode type device and/or element configured to generate and emit a laser beam, i.e. a beam of laser light. By way of example, a laser diode may be a semiconductor laser diode. In this context the term "light" should be allowed a broad interpretation, not limited to visible electromagnetic radiation. Rather, the term "light" may also include for example ultra-violet light and infra-red light. The frequency content of the light of the laser beam typically falls within a narrow frequency range. For simplicity, the peak of the frequency range is referred to as "the frequency" of the laser, although it is not necessarily a single frequency but may be frequencies within a narrow frequency range. The width of the frequency range, and typically the full width at half maximum (FWHM), is referred to as the linewidth of the laser beam.

The laser diode may be configured to provide a laser beam of laser light which is coherent. Coherent light may be advantageous as it may improve the optical performance of the application in which the laser apparatus is applied.

The laser diode is configured for frequency modulation of the laser beam. Thus, by influence external to the laser diode, the frequency of the laser beam may be altered. By way of example, the frequency may be dependent on, and may thus be altered by variations in, a temperature of the laser diode and/or a drive current provided to the laser diode. Frequency modulation of the laser beam may therefore be provided by modulation of temperature of the laser diode and/or by modulation of the drive current through the laser diode.

The first portion of the laser beam may be split off from the path of the laser beam emitted from the laser diode, leaving the second portion of the laser beam remaining in the path. The first portion of the laser beam may be provided to the sensor unit, whereas the second portion of the laser beam may continue to propagate towards an output of the laser apparatus. Typically, the power of the second portion of the laser beam is higher than the power of the first portion of the laser beam.

The phase shifter arranged in the path of the second portion of the laser beam may generate a phase shift of the second portion of the laser beam as the second portion of the laser beam propagates through the phase shifter, prior to the second portion of the laser beam being output from the laser apparatus. By the environment external to the laser apparatus, an external reflection may result from the output laser beam. Since the phase shifter may control the phase of the output laser beam, it may also control the phase of such an external reflection. The external reflection of the output laser beam may return towards the laser apparatus such that the external reflection is received by the laser apparatus and such that the external reflection is reflected into the laser diode. In such an event, the linewidth of the laser beam from the laser diode may be affected, due to interference from the external reflection. By way of example, the linewidth of the laser beam may be broadened, or it may be narrowed, depending on the phase of the external reflection with respect to the phase of the laser beam of the laser diode. Thus, by controlling the phase shift, generated by the phase shifter, of the second portion of the laser beam, the linewidth of the laser beam of the laser diode may be controlled.

It serves to mention that the external reflection may be, but is not limited to, a single external reflection. Alternatively, the external reflection may be a result of a combination of multiple external reflections.

Further, if the phase of the external reflection is such that a minimum in the linewidth is obtained, then also the variations of the frequency, and more specifically the frequency tuning range, during frequency modulation of the laser beam will reach a minimum. Hence, the frequency tuning range during frequency modulation may be monitored in order to find the phase shift for which a minimum linewidth of the laser beam is obtained.

In order to monitor properties of the laser beam, the first portion of the laser beam may be split off from the path of the laser beam emitted from the laser diode, and may be provided to the sensor unit. The sensor unit is configured for measuring variations of the frequency of the first portion of the laser beam. Since the first portion of the laser beam is split off from the path of the laser beam emitted from the laser diode, the variations of the frequency of the first portion of the laser correspond to the variations of the frequency of the laser beam as well as of the second portion of the laser beam.

By way of example, measurements of variations of the frequency may be provided by converting the variations of the frequency to variations of a power of the first portion of the laser beam, and to subsequently measure the variations of the power. Given as non-limiting examples, conversion of the variations of the frequency to variations of power may be provided by passing the first portion of the laser beam through a conversion element, such as an optical filter or a Fabry-Pérot cavity. The subsequent measuring of the variations of the power may be provided by a photo sensitive element.

It serves to mention that when referring to the amount of light in a light beam, such as a laser beam, the terms "power" and "intensity" are commonly used. By the term "intensity" of light is here meant the "power" of light per surface area. However, although the two terms have slightly different definitions they are certainly linked and in the present context, the terms "power" and "intensity" may be used interchangeably. For example, when using a photo sensitive element to measure the power of a laser beam, what is measured is the power of light incident onto the surface area of the photo sensitive element, thus the intensity. However, provided that the full cross-section of the laser beam fits within the surface area of the photo sensitive element, the photo sensitive element may measure the power of the full laser beam. Thus, the electric signal generated by the photo sensitive element may be proportional to the power as well as the intensity of the laser beam.

The laser apparatus is configured to acquire, by the sensor unit, a plurality of measurements of variations of the frequency during frequency modulation at a plurality of different phase shifts generated by the phase shifter. In this manner, the laser apparatus may determine the variations of the frequency, and more specifically the width of the frequency tuning range, for different phase shifts. Since the frequency tuning range is linked to the linewidth of the laser beam, the plurality of measurements may be used as a measure of the linewidth of the laser beam.

The arrangement described above forms part of an electro-optic feedback loop, provided to control the phase shifter based on the plurality of measurements so as to control the variations of the frequency. By the present arrangement, the laser apparatus is configured to control the linewidth of the laser beam by controlling the phase shift of the external reflection, received by the laser apparatus, with respect to the phase of the laser beam of the laser diode.

By way of example, the laser apparatus may control the phase shifter based on the plurality of measurements so as to provide a minimum in the variations of the frequency. Thereby, a minimum of the linewidth of the laser beam may be provided.

An advantage with the present disclosure is that a laser apparatus may be provided, wherein control of the linewidth of the laser beam is provided such that undesired linewidth broadening as a result of external reflections may be reduced or eliminated.

Another advantage is that the need for using an optical isolator in front of the laser diode in order to suppress external reflections may be eliminated, which is otherwise a conventional solution. An optical isolator comprises magneto-optic materials, and therefore suffers from the disadvantage that it may not be integrated on the same substrate as the laser diode. Thus, an additional advantage with the present disclosure is that the sensor unit and phase shifter may be integrated onto the same substrate as the laser diode. By the present arrangement, a more compact and stable laser apparatus that reduces or eliminates the negative effects of external reflections may be provided.

Yet another advantage is that, by the present arrangement, the external reflection may be used to provide a more narrow linewidth of the laser beam than otherwise provided by the laser diode alone. A narrow linewidth of the laser beam may be an advantage in several laser based application, and may thus improve the performance of the laser apparatus in such application. By way of example, the laser apparatus may be applied as a laser source in applications requiring narrow laser linewidth, such as optical communications, optical sensing, laser-induced fluorescence (LIF), and light detection and ranging (LIDAR). Given only as an example, a linewidth of 1 MHz may be reduced to 25 kHz, by the present arrangement.

According to an embodiment, the sensor unit comprises:

> a conversion element arranged in a path of the first portion of the laser beam, and configured to convert the variations of the frequency of the first portion of the laser beam into variations of a power of the first portion of the laser beam propagating through the conversion element; and
> a photo sensitive element configured for generating an electric signal dependent on an intensity of light incident onto the photo sensitive element;
> wherein the photo sensitive element is arranged such that the first portion of the laser beam is incident onto the photo sensitive element, after propagation of the first portion of the laser beam through the conversion element.

By the term "conversion element" is here meant any optical unit and/or element able to convert variations of the frequency of light passing therethrough, to variations of power of the light. Given as non-limiting examples, the conversion element may be an optical filter or a Fabry-Pérot cavity. For example, a Fabry-Pérot cavity may function as an interferometer in which constructive and/or destructive interference of the light passing therethrough may result, depending on the optical path length through the Fabry-Pérot cavity with respect to the frequency, and thus wavelength, of the light. The interference may change as the frequency of the light changes, thereby resulting in changes in power of the light exiting the Fabry-Pérot cavity. By way of further example, the conversion element may alternatively be a ring resonator, a Bragg grating, or a Mach-Zehnder interferometer.

By the term "photo sensitive element" is here meant any element reacting to light impinging onto the element, by generating an electric signal as a response to the light intensity and/or power. Given as non-limiting examples, photo sensitive elements may be found on photodiodes, photomultiplier tubes (PMT), and pixels on image detectors such as charge-coupled devices (CCD) and complementary metal oxide semiconductors (CMOS).

An advantage with this embodiment is that a simple, reliable and robust sensor unit for measuring frequency variations may be provided.

According to an embodiment, the conversion element comprises a Fabry-Pérot cavity.

According to an embodiment, the sensor unit is further configured for measuring variations of the power of the first portion of the laser beam.

It should be understood that modulation of the frequency of the laser diode may result in variations of power output from the laser diode in addition to the variations of frequency of the laser beam. After conversion of the variations of the frequency into variation of power, the photo sensitive element may thus measure variations related to a combination of variations of frequency and variations of power. Therefore, it may be difficult for a single photo sensitive element to distinguish between the power variations related to variations of frequency and variations of power output from the laser diode. A sensor unit may therefore be configured for measuring the variations of the power of the first portion of the laser beam as well as measuring the variations of frequency. By way of example, by splitting the first portion of the laser beam, e.g. by a 50/50 beam splitter, measurements of variations of power and frequency may be provided, such that one part may be used to measure variations of frequency as previously described, whereas the other part may be guided directly to a further photo sensitive element to measure variations of power. The measured variations of frequency, which may also comprise variations of power, may subsequently be compensated for the measured variations of power, thereby providing measurements of variations of the frequency without the influence of variations of power of the output of the laser diode.

An advantage with this embodiment is that a laser apparatus with improved measurements of variations of the frequency may be provided, with reduced or eliminated influence of variations of power output from the laser diode resulting from the modulation of frequency of the laser diode. Consequently, with improved measurements of variations of the frequency, also improved control of the phase shift and thus of the linewidth of the laser beam may be provided.

According to an embodiment, the phase shifter is a thermo-optic phase shifter.

By the term "thermo-optic phase shifter" is here meant a phase shifter that provides a tunable phase shift as a function of the temperature of the phase shifter. Thus by controlling the temperature of the phase shifter, the resulting phase shift may be controlled. Given as a non-limiting example, a thermo-optic phase shifter may be realized as a heater provided on a silicon-on-insulator waveguide, through which the second portion of the laser beam may propagate. By heating a waveguide, the refractive index of the waveguide may change, and typically increase. As the refractive index changes, typically the optical path length through the phase shifter is changed, thereby changing the phase of the light exiting the phase shifter.

An advantage with this embodiment is that a simple yet easily controllable implementation of a phase shifter.

Another advantage is that it allows for integration onto the same substrate as the laser diode, providing a compact laser apparatus.

It serves to mention that the phase shifter is not limited to being a thermo-optic phase shifter. By way of example, the phase shifter may alternatively be an electro-optic phase shifter. By way of example, an electro-optic phase shifter may be provided by depositing an electro-optic material such as $LiNbO_3$ on an Si waveguide and applying a voltage on the $LiNbO_3$, or by making a pin junction in an Si waveguide and injecting charge carriers to change the refractive index.

According to an embodiment, the laser apparatus further comprises a control unit configured for controlling the phase shifter based on the plurality of measurements so as to control the variations of the frequency, thereby controlling the linewidth of the laser beam in dependence of the external reflection of the second portion of the laser beam being output, received by the laser apparatus.

The control unit may be configured to receive and/or acquire the plurality of measurements of the variations of the frequency during frequency modulation at the plurality of different phase shifts generated by the phase shifter. By way of example, the control unit may be directly or indirectly connected to one or more photo sensitive elements of the sensor unit. The control unit may further be configured to process the measurements, as for example by compensating measurements of variations of frequency for measurements of variations of power. The control unit may further be configured to, based on the measurements, determine a relation between linewidth and variations of frequency. By way of example, the control unit may be configured to, based on the measurements, determine a phase shift for which a minimum in variations of frequency is provided. Thus, the control unit may be configured to control the phase shifter so as to control the linewidth of the laser beam. By way of example, the control unit may be configured to control the phase shifter such that a minimum linewidth of the laser beam is provided.

An advantage with this embodiment is that with a dedicated control unit a laser apparatus with a compact, fast, and on-board control may be provided, without the need for external processing of the plurality of measurements.

According to an embodiment, the sensor unit further comprises a lock-in amplifier configured for measuring the variations of the frequency of the first portion of the laser beam, and for providing the plurality of measurements of the variations of the frequency during frequency modulation to the control unit.

An advantage with this embodiment is that an improved signal-to-noise ratio of the measurements of variations of the frequency may be provided. This, in turn, may provide improved control of the linewidth of the laser beam and thus improved performance of the laser apparatus.

According to an embodiment, frequency modulation of the laser beam is provided by modulation of a drive current of the laser diode and/or modulation of a temperature of the laser diode.

According to an embodiment, the laser diode is a single mode laser diode.

It is conceivable, however, that the laser diode may alternatively be a multimode laser.

According to an embodiment, an active laser medium of the laser diode comprises quantum dots.

In case the intensity of the external reflection is too high, i.e. an effective external reflectivity is above a certain threshold, the laser diode may reach what is referred to as the coherence collapse regime, wherein the laser diode loses its coherent light properties. In applications requiring laser light, such a coherence collapse is unwanted since the light propertied needed for the application are lost.

An advantage with this embodiment is that, for laser diodes using an active laser medium comprises quantum dots, the risk of reaching coherence collapse is reduced or even eliminated, even at high intensity external reflections.

According to an embodiment, the laser diode, the sensor unit, and the phase shifter are integrated onto a common substrate.

An advantage with this embodiment is that a more compact and stable laser apparatus may be provided, that reduces or eliminates the negative effects of external reflections. The conventional approach of using an optical isolator in front of the laser diode to suppress external reflections, may not be integrated on the same substrate as the laser diode, resulting in a bulky solution. However, according to the present disclosure the need for such an optical isolator may be eliminated, and a more compact laser apparatus may be provided.

According to a second aspect there is provided a method for controlling a linewidth of a laser beam emitted by a laser diode of a laser apparatus, the method comprising:

emitting, by a laser diode, a laser beam;

frequency modulating the laser beam;

receiving, at a sensor unit, a first portion of the laser beam;

measuring, by the sensor unit, variations of the frequency of the first portion of the laser beam;

generating, by a phase shifter arranged in a path of a second portion of the laser beam, a phase shift of the second portion of the laser beam propagating though the phase shifter;

outputting, from the laser apparatus, the second portion of the laser beam having propagated through the phase shifter;

acquiring, by the sensor unit, a plurality of measurements of variations of the frequency during frequency modulation at a plurality of different phase shifts generated by the phase shifter;

controlling the phase shifter based on the plurality of measurements so as to control the variations of the frequency, whereby the linewidth of the laser beam is controlled in dependence of an external reflection of the second portion of the laser beam being output, received by the laser apparatus.

Effects and features of the second aspect are largely analogous to those described above in connection with the first aspect. Embodiments mentioned in relation to the first aspect are largely compatible with the second aspect. It is further noted that the inventive concepts relate to all possible combinations of features unless explicitly stated otherwise.

Other objectives, features and advantages of the present inventive concept will appear from the following detailed disclosure, from the attached claims as well as from the drawings.

Brief descriptions of the drawings

The above, as well as additional objects, features and advantages of the present description, will be better understood through the following illustrative and non-limiting detailed description, with reference to the appended drawings. In the drawings like reference numerals will be used for like elements unless stated otherwise.

Fig. 1 schematically illustrates a laser apparatus configured to control the linewidth of the emitted laser beam by means of an external reflection of the laser beam, returned to and received by the laser apparatus.

Fig. 2 schematically illustrates a laser apparatus configured for monitoring variations of power of the laser beam as well as variations of the frequency.

Fig 3A illustrates a diagram of the effect of a single external reflection on the laser linewidth of a laser diode.

Fig. 3B illustrates a diagram of $\omega_0$ as a function of $\omega$ of a laser diode, for one and two external reflections, respectively.

Fig. 4 illustrates a schematic block diagram shortly summarizing the method for controlling a linewidth of a laser beam emitted by a laser diode of a laser apparatus.

Detailed description

In cooperation with attached drawings, the technical contents and detailed description of the present inventive concept are described thereinafter according to a preferable embodiment, being not used to limit the claimed scope. This inventive concept may be embodied in many different forms and should not be construed as limited to the embodiments set forth herein; rather, these embodiments are provided for thoroughness and completeness, and fully convey the scope of the inventive concept to the skilled person.

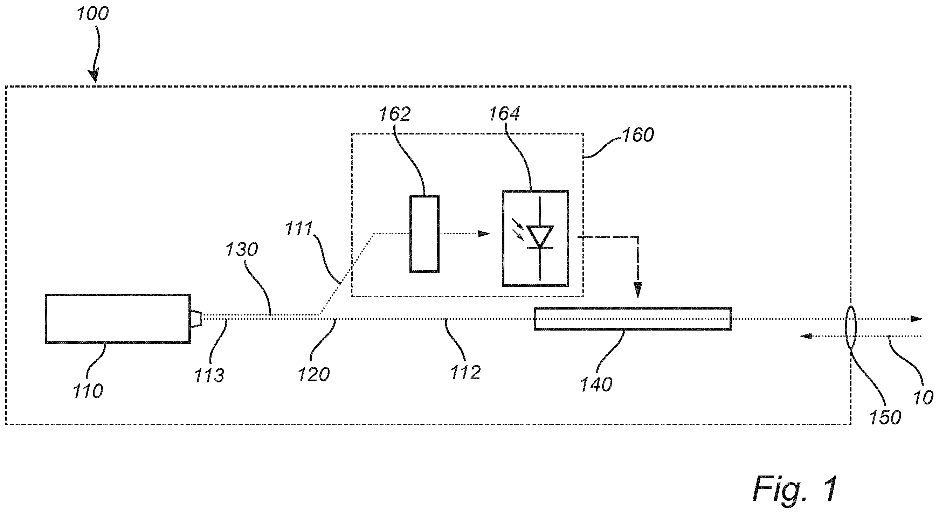

Fig. 1 schematically illustrates a laser apparatus 100. The laser apparatus 100 is configured to control the linewidth of the emitted laser beam by means of an external reflection of the laser beam, returned to and received by the laser apparatus 100.

The laser apparatus 100 comprises a laser diode 110. The laser diode 110 is configured to emit a beam of laser light, a laser beam 113, of a specific frequency of light. The laser diode 110 may be a semiconductor laser. The laser diode 110 is further configured for frequency modulation of the laser beam 113. In other words, the frequency of the light of the laser beam 113 may be altered and thus modulated by influence external to the laser diode 110. By way of example, frequency modulation of the laser beam 113 may be provided by modulation of the drive current of the laser diode 110. By way of further example, frequency modulation of the laser beam 113 may be provided by modulation of a temperature of the laser diode 110.

The laser beam 113 emitted from the laser diode 110 is divided into two paths. A first portion 111 of the laser beam 113 follows one path and a second portion 112 of the laser beam 113 follows another path. As illustrated in Fig. 1, the first portion 111 deviates from the original path of the laser beam 113, whereas the second portion 112 continues along the original path. However, it should be understood that other alternatives are equally possible, such as the first portion 111 continues along the original path and the second portion 112 is deviated from the original path, or that both the first portion 111 and the second portion 112 deviate in different directions from the original path.

Division of the laser beam 113 into the first and second portions 111, 112 may be provided in a number of different manners. For example, division of the laser beam 113 may be provided by a beam splitter or a grating. Alternatively, in case the laser beam 113 output from the laser diode 110 is propagating through a waveguide 120, a coupler 130 in the form of another waveguide arranged alongside, spaced apart from, and parallel to the waveguide 120 may couple some of the light of the laser beam 113 into the coupler, as the first portion 111 of the laser beam 113. The light remaining in the waveguide 120 will thus be the second portion 112 of the laser beam 113.

The laser apparatus 100 further comprises a phase shifter 140 arranged in the path of a second portion 112 of the laser beam 113. The phase shifter 140 is configured to generate a phase shift of the second portion 112 of the laser beam 113 propagating through the phase shifter 140. By way of example, a phase shift may be provided by altering the temperature of the optical medium through which the second portion 112 of the laser beam 113 propagates. A change in temperature may cause a change in optical path length through the medium through which the second portion 112 of the laser beam 113 propagates, and thus a change in phase. The present arrangement is referred to as a thermo-optic phase shifter.

After the second portion 112 of the laser beam 113 has propagated through the phase shifter 140, the phase shifted second portion 112 is output from the laser apparatus 100 through an output 150. Thus, the phase shifter 140 may control the phase of the laser light exiting the laser apparatus 100. By the environment external to the laser apparatus 100, the output laser beam may be reflected, forming an external reflection 10. Since the phase shifter 140 may control the phase of the output laser beam, the phase shifter 140 may also control the phase of the external reflection 10. The external reflection 10 may return towards the laser apparatus 100 and may pass through the output 150 into the laser apparatus 100 and into the laser diode 110. In such an event, the linewidth of the laser beam 113 from the laser diode 110 may be affected, due to interference from the external reflection. The linewidth of the laser beam 113 may be broadened or narrowed, depending on the phase of the external reflection 10 with respect to the phase of the laser beam 113 of the laser diode 110.

The laser apparatus 100 further comprises a sensor unit 160. The sensor unit 160 receives the first portion 111 of the laser beam 113. The sensor unit 160 is configured for measuring variations of the frequency of the first portion 111 of the laser beam 113, and thus also of the laser beam 113, during frequency modulation. As illustrated in Fig. 1, the sensor unit 160 comprises a conversion element 162 arranged in the path of the first portion 111 of the laser beam 113. The conversion element 162 is configured to convert the variations of the frequency of the first portion 111 of the laser beam 113 into variations of power of the first portion 111 of the laser beam 113 propagating through the conversion element 162. Such conversion may be provided by for example a Fabry-Pérot cavity or various types of optical filters.

The sensor unit 160 further comprises a photo sensitive element 164. The photosensitive element 164 is arranged such that the first portion 111 of the laser beam 113 is incident onto the photosensitive element 164 after having propagated though the conversion element 162. Thus, the frequency variations of the first portion 111 of the laser beam 113 are converted to power variations by the conversion element 162, which power variations are subsequently measured by the photosensitive element 164.

By the present arrangement, the laser apparatus 100 may acquire, by the sensor unit 160, a plurality of measurements of the variations of the frequency during frequency modulation. Such measurement may be acquired at a plurality of different phase shifts generated by the phase shifter 140. In this manner, the laser apparatus 100 may determine the variations of the frequency, and more specifically the width of the frequency tuning range, for different phase shifts. Since the range of the variations of the frequency is linked to the linewidth of the laser beam 113, the measurements may be used as an indication of the linewidth of the laser beam 113. The phase shifter 140 may be controlled based on the plurality of measurements, whereby the range of the variations of the frequency may be controlled. By the present arrangement, the laser apparatus 100 may control the linewidth of the laser beam 113, by controlling the phase of the second portion 112 of the laser beam 113 being output, and thus the phase of the external reflection 10 received by the laser apparatus. By way of example, the laser apparatus 100 may provide a minimum of the linewidth of the laser beam 113 by controlling the phase shifter 140 so as to provide a minimum in the variations of the frequency.

In the manner described above, an electro-optic feedback loop that may optimize the phase of the external reflection 10 such that the laser diode 110 provides the narrowest linewidth may be provided. The present arrangement may further enable automatic tuning of the phase shifter 140.

Given only as an example, the laser diode 110, the sensor unit 160, and the phase shifter 140 may all be integrated onto a common substrate, providing a compact laser apparatus 100.

By way of example, the laser diode 110 may be, but is not limited to, a single mode laser diode. By way of further example, the active laser medium of the laser diode 110 may comprise, but is not limited to, quantum dots.

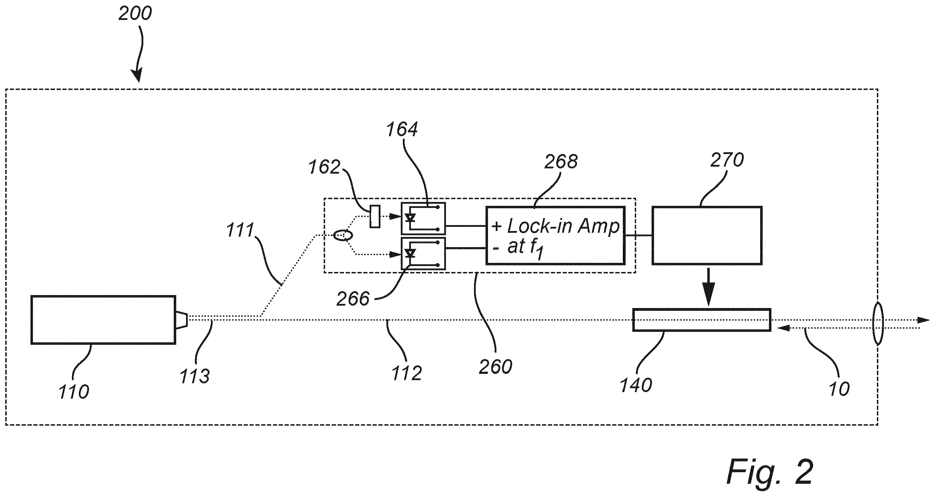

Fig. 2 schematically illustrates a laser apparatus 200. Similar to laser apparatus 100, the laser apparatus 200 comprises a laser diode 110, configured to emit a laser beam 113, and configured for frequency modulation of the laser beam 113. The laser apparatus 200 is configured for measuring variations of the power of the laser beam 113 as well as variations of the frequency, during frequency modulation. The laser apparatus 200 shares some of the features with laser apparatus 100 described in relation to Fig. 1, the details of which are not repeated here.

It is conceivable that, during frequency modulation of the laser beam 113, not only the frequency of the light may be modulated but possibly also the power of the laser beam 113 output from the laser diode 110. In such a case, after conversion of the variations of the frequency into variations of power, the power variations of the light may be related to a combination of variations of frequency and variations of power. By means of a single photo sensitive element 164 it may be difficult to distinguish between the power variations related to variations of frequency and variations of power output from the laser diode 110.

In order to provide more accurate measurements of the variations of the frequency and thus a better control of the laser linewidth, the laser apparatus 200 comprises a sensor unit 260. Similar to the sensor unit 160, the sensor unit 260 comprises a conversion element 162 and a photo sensitive element 164. Additionally the sensor unit 260 comprises a further photo sensitive element 266. In the sensor unit 260 the first portion 111 of the laser beam 113 may be further split into two paths. Along one path, the light propagates through the conversion element 162 and continues to the photo sensitive element 164, in a similar manner as described for laser apparatus 100 in relation to Fig. 1. Along the other path, the light propagates directly to the further photo sensitive element 266, without passing through any conversion element. The further photo sensitive element 266 may thus be used to measure the variations of the power of the laser beam 113, resulting from the modulation. The measurements by the further photo sensitive element 266 may be used to compensate the measurement by the photo sensitive element 164 for variations of laser output power. By the present arrangement, the effects of laser output power variations may be reduced or eliminated from the measurement of the photo sensitive element 164, so as to provide a measurement of the variations of the frequency during frequency modulation.

The laser apparatus 200 further comprises a control unit 270. The control unit 270 is connected to the sensor unit 260 such that the control unit 270 may receive measurement signals from the sensor unit 260. The control unit 270 is configured for controlling the phase shifter 140 based on the measurements made by the sensor unit 260 so as to control the variations of the frequency during frequency modulation. The control unit 270 may thereby control the linewidth of the laser beam 113, by controlling the phase of the second portion 112 of the laser beam 113 being output, and thus the phase of the external reflection 10 received by the laser apparatus 200. By way of example, the laser apparatus 200 may provide a minimum of the linewidth of the laser beam 113 by controlling the phase shifter 140 so as to provide a minimum in the variations of the frequency.

The sensor unit 260 may optionally comprise a lock-in amplifier 268. The lock-in amplifier 268 may be connected to the photo sensitive element 164 and the further photo sensitive element 266 such that the lock-in amplifier 268 may receive the measurement signals from the photo sensitive elements 164, 266. The lock-in amplifier 268 may be configured for measuring the variations of the frequency of the first portion 111 of the laser beam 113. The lock-in amplifier 268 may be further configured for providing the plurality of measurements of the variations of the frequency during frequency modulation to the control unit 270. The lock-in amplifier 268 may be provided in order to provide an improved signal-to-noise ratio of the measurements. Improved signal-to-noise ratio may provide improved control of the linewidth of the laser beam 113 and thus improved performance of the laser apparatus 200.

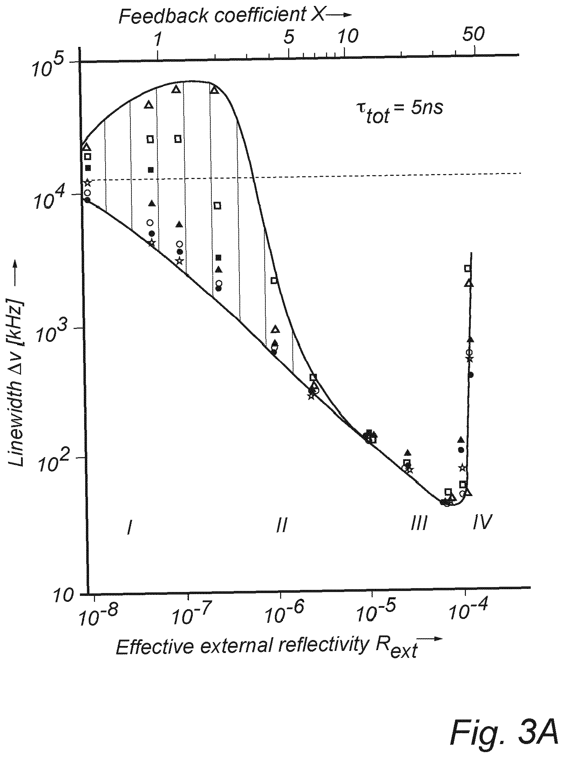

Fig. 3A illustrates a diagram of the effect of a single external reflection on the laser linewidth of a laser diode. Fig. 3A is based on a figure presented in K. Petermann, "External Optical Feedback Phenomena in Semiconductor Lasers", IEEE Journal of selected topics in quantum electronics, Vol. 1, No. 2, June 1995.

Fig. 3A shows the linewidth of the laser beam as a function of external reflectivity and as a function of the feedback coefficient, for different phases of the external reflection. In the present disclosure, a cavity referred to as the external cavity is considered to be formed between the laser diode and the external reflector causing the external reflection. The time it takes for the light of the laser beam to travel from laser diode to external reflector and back to the laser diode is here referred to as the external cavity roundtrip time. In the present example, the external cavity roundtrip time is 5 ns.

The diagram is divided into four regions designated I, II, III, and IV. Region IV is referred to as the coherence collapse regime. In the coherence collapse regime the intensity of the external reflection is high, i.e. the effective external reflectivity is above a certain threshold, and consequently the laser diode may lose its coherent light properties. It is undesired to reach the coherence collapse regime, and it may be avoided for example by ensuring that the external reflectivity is below the threshold or by using an active laser medium comprising quantum dots.

The horizontal dashed line represents the linewidth of the laser beam with no feedback from external reflections. With feedback from external reflections, however, the linewidth may either be broadened with respect to the original laser linewidth, or the linewidth may be narrowed with respect to the original laser linewidth. Depending on the phase of the external reflection, the linewidth may fall anywhere between the two solid lines. Thus, from the diagram it is clear that, if coherence collapse can be avoided, there is always a reflection phase which may result in linewidth narrowing, regardless of the level of external reflectivity.

For a single external reflection, the linewidth $\Delta v$ under feedback of the external reflection is given by the expression:

$$\Delta v = \Delta v_0/\{1 + X \cos[\omega\tau + arctg(\alpha)]\}^2$$

wherein $\Delta v_0$ is the linewidth of the laser beam without feedback of any external reflection, and $X$ the feedback coefficient. The feedback coefficient $X$ is proportional to the external reflectivity $R_{ext}$ and to the external cavity roundtrip time $\tau_e$. Further, $\omega$ is the angular emission frequency of the laser diode when under feedback of the external reflection, and $\alpha$ is referred to as the linewidth enhancement factor.

Similarly, for the angular emission frequency $\omega$ it may be derived that:

$$\omega_0\tau = \omega\tau + X \sin[\omega\tau + arctg(\alpha)]$$

wherein $\omega_0$ is the angular emission frequency of the laser beam without feedback of any external reflection. It follows from the previous expression that if the frequency of the laser is tuned, for example thermally or electronically, the tuning is given by the expression:

$$\Delta\omega = \Delta\omega_0 /\{1 + X \cos[\omega\tau + arctg(\alpha)]\}$$

From the expressions for the linewidth $\Delta v$ and the tuning $\Delta\omega$ above, it can be seen that the two properties both reach a minimum for an external reflection with the same phase. Thus, the tuning of the laser under feedback of the external reflection will reach a minimum if the phase of the feedback is such that also linewidth reaches a minimum. Or, in other words, minimal linewidth will be obtained when the phase of the feedback is such that minimal tuning under feedback is obtained.

The theory may be extended also to multiple external reflections. In such a case the linewidth is given by the expression:

$$\Delta v = \Delta v_0/\left\{1 + \sum_i X_i \cos[\omega\tau_i + arctg(\alpha)]\right\}^2$$

and the tuning is given by the expression:

$$\Delta\omega = \Delta\omega_0 /\left\{1 + \sum_i X_i \cos[\omega\tau_i + arctg(\alpha)]\right\}$$

Also in this case, if coherence collapse can be avoided, the linewidth of the laser beam will reach a minimum for external reflection properties that also provide the tuning to reach a minimum.

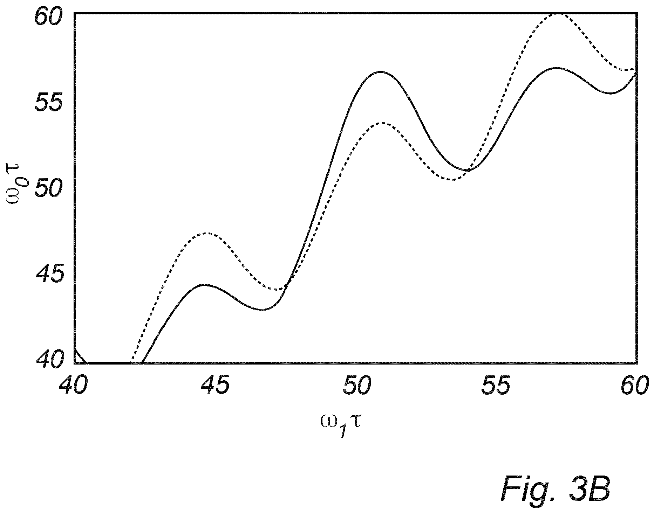

Fig. 3B illustrates a diagram of $\omega_0$ as a function of $\omega$, for one and two external reflections, respectively. For the curve representing a laser receiving one external reflection, i.e. the dashed line, $X = 3$ and $\tau_1 = \tau =$ varied. For the curve representing a laser receiving two external reflections, i.e. the solid line, $X = 3$ for both reflections and $\tau_1 = \tau$ and $\tau_2 = \tau/2$. Minimum tuning, and thus minimum linewidth, is obtained when the slope of the curve, thus $d\omega_0/d\omega$, in Fig. 3B reaches a maximum. Equally, minimum tuning, and thus minimum linewidth, is obtained when the slope of the curve, thus $d\omega/d\omega_0$, in Fig. 3B reaches a minimum.

From the presented theory, it is clear that control of the linewidth of the laser beam may be provided based on measurements of the tuning of the laser diode during frequency modulation. For example, by controlling the phase of the external reflection such that minimum tuning is provided, then also minimum linewidth of the laser beam may be provided.

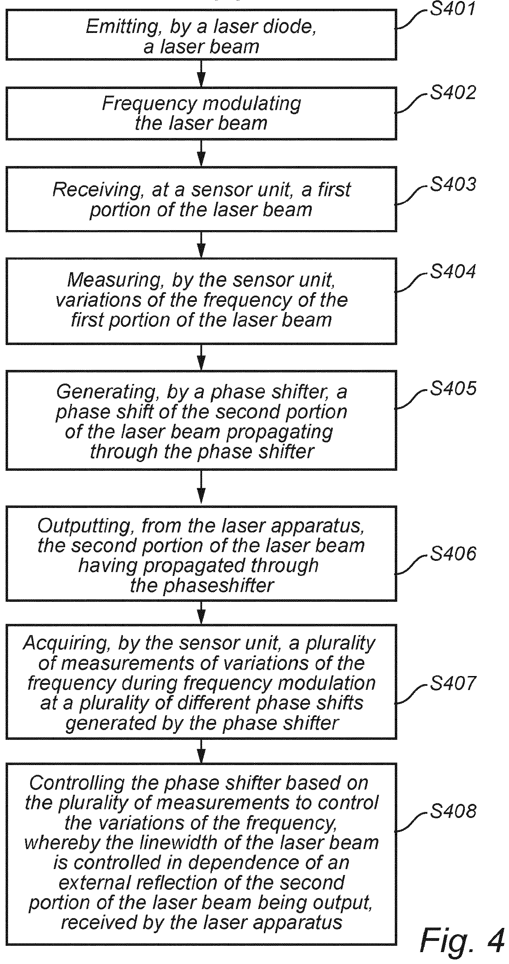

Fig. 4 illustrates a schematic block diagram shortly summarizing the method for controlling a linewidth of a laser beam emitted by a laser diode of a laser apparatus. It should be understood that the steps of the method, although listed in a specific order herein, may be performed in any order suitable.

The method may comprise emitting S401, by a laser diode, a laser beam.

The method may comprise frequency modulating S402 the laser beam.

The method may comprise receiving S403, at a sensor unit, a first portion of the laser beam.

The method may comprise measuring S404, by the sensor unit, variations of the frequency of the first portion of the laser beam.

The method may comprise generating S405, by a phase shifter arranged in a path of a second portion of the laser beam, a phase shift of the second portion of the laser beam propagating though the phase shifter.

The method may comprise outputting S406, from the laser apparatus, the second portion of the laser beam having propagated through the phase shifter.

The method may comprise acquiring S407, by the sensor unit, a plurality of measurements of variations of the frequency during frequency modulation at a plurality of different phase shifts generated by the phase shifter.

The method may comprise controlling S408 the phase shifter based on the plurality of measurements so as to control the variations of the frequency, whereby the linewidth of the laser beam is controlled in dependence of an external reflection of the second portion of the laser beam being output, received by the laser apparatus.

In the above the inventive concept has mainly been described with reference to a limited number of examples. However, as is readily appreciated by a person skilled in the art, other examples than the ones disclosed above are equally possible within the scope of the inventive concept, as defined by the appended claims.

**Claims**

1. A laser apparatus (100, 200) comprising:

   a laser diode (110) configured to emit a laser beam (113), wherein the laser diode (110) is further configured for frequency modulation of the laser beam (113);
   a sensor unit (160, 260) configured to receive a first portion (111) of the laser beam (113), wherein the sensor unit (160, 260) is further configured for measuring variations of the frequency of the first portion (111) of the laser beam (113);
   a phase shifter (140) arranged in a path of a second portion (112) of the laser beam (113), and configured to generate a phase shift of the second portion (112) of the laser beam (113) propagating through the phase shifter (140);
   wherein the laser apparatus (100, 200) is configured to output the second portion (112) of the laser beam (113) having propagated through the phase shifter (140); and
   wherein the laser apparatus (100, 200) is configured to acquire, by the sensor unit (160, 260), a plurality of measurements of the variations of the frequency during frequency modulation at a plurality of different phase shifts generated by the phase shifter (140), and to control the phase shifter (140) based on the plurality of measurements so as to control the variations of the frequency, whereby the laser apparatus (100, 200) is configured to control a linewidth of the laser beam (113) in dependence of an external reflection (10) of the second portion (112) of the laser beam (113) being output, received by the laser apparatus (100, 200).

2. The laser apparatus (100, 200) according to claim 1, wherein the sensor unit (160, 260) comprises:

   a conversion element (162) arranged in a path of the first portion (111) of the laser beam (113), and configured to convert the variations of the frequency of the first portion (111) of the laser beam (113) into variations of a power of the first portion (111) of the laser beam (113) propagating through the conversion element (162); and
   a photo sensitive element (164) configured for generating an electric signal dependent on an intensity of light incident onto the photo sensitive element (164);
   wherein the photo sensitive element (164) is arranged such that the first portion (111) of the laser beam (113) is incident onto the photo sensitive element (164), after propagation of the first portion (111) of the laser beam (113) through the conversion element (162).

3. The laser apparatus (100, 200) according to claim 2, wherein the conversion element (162) comprises a Fabry-Pérot cavity.

4. The laser apparatus (200) according to any of the preceding claims, wherein the sensor unit (260) is further configured for measuring variations of the power of the first portion (111) of the laser beam (113).

5. The laser apparatus (100, 200) according to any of the preceding claims, wherein the phase shifter (140) is a thermo-optic phase shifter.

6. The laser apparatus (200) according to any of the preceding claims, further comprising a control unit (270) configured for controlling the phase shifter (140) based on the plurality of measurements so as to control the variations of the frequency, thereby controlling the linewidth of the laser beam (113) in dependence of the external reflection (10) of the second portion (112) of the laser beam (113) being output, received by the laser apparatus (200).

7. The laser apparatus (200) according to claim 6, wherein the sensor unit (260) further comprises a lock-in amplifier (268) configured for measuring the variations of the frequency of the first portion (111) of the laser beam (113), and for providing the plurality of measurements of the variations of the frequency during frequency modulation to the control unit (270).

8. The laser apparatus (100, 200) according to any of the preceding claims, wherein frequency modulation of the laser beam (113) is provided by modulation of a drive current of the laser diode (110) and/or modulation of a temperature of the laser diode (110).

9. The laser apparatus (100, 200) according to any of the preceding claims, wherein the laser diode (110) is a single mode laser diode.

10. The laser apparatus (100, 200) according to any of the preceding claims, wherein an active laser medium of the laser diode (110) comprises quantum dots.

11. The laser apparatus (100, 200) according to any of the preceding claims, wherein the laser diode (110), the sensor unit (160, 260), and the phase shifter (140) are integrated onto a common substrate.

12. A method for controlling a linewidth of a laser beam emitted by a laser diode of a laser apparatus, the method comprising:

emitting S401, by a laser diode, a laser beam;
frequency modulating S402 the laser beam;
receiving (S403), at a sensor unit, a first portion of the laser beam;
measuring (S404), by the sensor unit, variations of the frequency of the first portion of the laser beam;
generating (S405), by a phase shifter arranged in a path of a second portion of the laser beam, a phase shift of the second portion of the laser beam propagating though the phase shifter;
outputting (S406), from the laser apparatus, the second portion of the laser beam having propagated through the phase shifter;
acquiring (S407), by the sensor unit, a plurality of measurements of variations of the frequency during frequency modulation at a plurality of different phase shifts generated by the phase shifter;
controlling (S408) the phase shifter based on the plurality of measurements so as to control the variations of the frequency, whereby the linewidth of the laser beam is controlled in dependence of an external reflection of the second portion of the laser beam being output, received by the laser apparatus.

Fig. 1

EP 4 425 726 A1

**200**

**164**

**162**

**268**

**270**

**111**

**+ Lock-in Amp**
**- at f₁**

**266**

**110**

**113**

**112**

**260**

**140**

**10**

*Fig. 2*

Fig. 3A

Fig. 3B

Emitting, by a laser diode,
a laser beam — S401

Frequency modulating
the laser beam — S402

Receiving, at a sensor unit, a first
portion of the laser beam — S403

Measuring, by the sensor unit,
variations of the frequency of the
first portion of the laser beam — S404

Generating, by a phase shifter, a
phase shift of the second portion
of the laser beam propagating
through the phase shifter — S405

Outputting, from the laser apparatus,
the second portion of the laser beam
having propagated through
the phaseshifter — S406

Acquiring, by the sensor unit, a plurality
of measurements of variations of the
frequency during frequency modulation
at a plurality of different phase shifts
generated by the phase shifter — S407

Controlling the phase shifter based on
the plurality of measurements to control
the variations of the frequency,
whereby the linewidth of the laser beam
is controlled in dependence of an
external reflection of the second
portion of the laser beam being output,
received by the laser apparatus — S408

*Fig. 4*

Europäisches
Patentamt

European
Patent Office

Office européen
des brevets

# EUROPEAN SEARCH REPORT

Application Number

EP 23 15 9062

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | VON DER WEID J P ET AL: "CHIRP AND FEEDBACK CONTROL IN SEMICONDUCTOR PIGTAILED DFB LASERS WITHOUT INTEGRATED ISOLATOR", ELECTRONICS LETTERS, THE INSTITUTION OF ENGINEERING AND TECHNOLOGY, GB, vol. 29, no. 1, 7 January 1993 (1993-01-07), pages 50-52, XP000403911, ISSN: 0013-5194 * page 50, right-hand column, paragraph 1 - page 51, right-hand column, paragraph 3; figures 1,2; table 1 * ----- | 1-12 | INV. H01S5/065 H01S5/00 H01S5/062 G01S7/481 ADD. H01S5/06 H01S5/0687 |
| X | US 4 979 178 A (BEAUSOLEIL RAYMOND G [US] ET AL) 18 December 1990 (1990-12-18) * column 2, line 30 - column 7, line 24; figures 1-7 * ----- | 1-8, 10-12 | |
| X | EUGENIO FASCI ET AL: "Narrow-linewidth quantum cascade laser at 8.6 [mu]m", OPTICS LETTERS, OPTICAL SOCIETY OF AMERICA, US, vol. 39, no. 16, 15 August 2014 (2014-08-15), pages 4946-4949, XP001591465, ISSN: 0146-9592, DOI: 10.1364/OL.39.004946 [retrieved on 2014-08-15] * page 4946, left-hand column, paragraph 2 - page 4949, left-hand column, paragraph 2; figures 1-5 * ----- | 1-4,6-9, 11,12 | TECHNICAL FIELDS SEARCHED (IPC) H01S G01S |

The present search report has been drawn up for all claims

| Place of search | Date of completion of the search | Examiner |
|---|---|---|
| Munich | 25 July 2023 | Laenen, Robert |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 23 15 9062**

This annex lists the patent family members relating to the patent documents cited in the above-mentioned European search report.
The members are as contained in the European Patent Office EDP file on
The European Patent Office is in no way liable for these particulars which are merely given for the purpose of information.

**25-07-2023**

| Patent document cited in search report | | Publication date | Patent family member(s) | Publication date |
|---|---|---|---|---|
| US 4979178 | A | 18-12-1990 | NONE | |

For more details about this annex : see Official Journal of the European Patent Office, No. 12/82

**EP 4 425 726 A1**

## REFERENCES CITED IN THE DESCRIPTION

**Non-patent literature cited in the description**

- **K. PETERMANN.** External Optical Feedback Phenomena in Semiconductor Lasers. *IEEE Journal of selected topics in quantum electronics,* June 1995, vol. 1 (2